# EUROPÄISCHE PATENTSCHRIFT

(11) **EP 1 774 057 B1**
(45) Veröffentlichungstag und Bekanntmachung des Hinweises auf die Patenterteilung: **02.09.2009**
(21) Anmeldenummer: 05762972.7
(22) Anmeldetag: 01.07.2005
(51) Int. Cl.: C23C 16/54

(54) **VORRICHTUNG UND VERFAHREN ZUR CHEMISCHEN GASPHASENABSCHEIDUNG MIT HOHEM DURCHSATZ**
DEVICE AND METHOD FOR HIGH-THROUGHPUT CHEMICAL VAPOR DEPOSITION
DISPOSITIF ET PROCEDE DE DEPOT CHIMIQUE EN PHASE VAPEUR A HAUT RENDEMENT

(30) Priorität: 06.08.2004 DE 102004038539; 20.11.2004 DE 102004056170
(43) Veröffentlichungstag der Anmeldung: 18.04.2007
(73) Patentinhaber: AIXTRON AG, 52134 Herzogenrath (DE)
(72) Erfinder: BAUMANN, Peter, 52072 Aachen (DE); STRYZEWSKI, Piotr, 52134 Herzogenrath (DE); SCHUMACHER, Marcus, 50171 Kerpen-Blatzheim (DE); LINDNER, Johannes, 52159 Roetgen (DE); KÜSTERS, Antonio, Mesquida, 52499 Baesweiler (DE)
(74) Vertreter: Grundmann, Dirk
(86) Internationale Anmeldenummer: PCT/EP2005/053134
(87) Internationale Veröffentlichungsnummer: WO 2006/015915

(56) Entgegenhaltungen:
- WO-A-02/40739
- WO-A-92/00406
- WO-A-03/016587
- WO-A-20/04094692
- DE-A1- 10 141 084
- US-A- 5 338 362

## Beschreibung

Die Erfindung betrifft eine Vorrichtung gemäß Gattungsbegriff des Anspruchs 1 und ein Verfahren gemäß Gattungsbegriff des Anspruchs 9.

Eine derartige Vorrichtung bzw. ein derartiges Verfahren beschreibt die WO2004/094692. Dort wird eine Multikammer-Vorrichtung für einen ALD-Prozess beschrieben. Auf einem Susceptor liegen Substrate, die nacheinander durch Drehen des Susceptors verschiedenen Abscheidekammern zugeführt werden, damit dort in zeitlich aufeinanderfolgenden Schritten Schichten oder Schichtkomponenten abgeschieden werden.

Aus der WO02/04739 A1 ist ein Verfahren zum Zuführen eines in die Gasform gebrachten flüssigen Ausgangsstoffes in einen CVD-Reaktor bekannt. Durch einen Flüssigkeitskanal wird eine Flüssigkeit in einen quer dazu verlaufenden Gasstrom injiziert. Es bildet sich ein Aerosol, welches durch Wärmezufuhr verdampft, wobei die Verdampfungswärme dem Gas entzogen wird.

Es ist ferner bekannt, in einer Prozesskammer nacheinander verschiedene Wachstumsschritte durchzuführen, wobei zwischen den einzelnen Wachstumsschritten die Gasphase innerhalb der Prozesskammer gespült und ausgetauscht wird. Bei jedem der verschiedenen Wachstumsschritte werden unterschiedliche Gasphasenzusammensetzungen verwendet. Es ist dabei auch vorgesehen, dass zyklisch verschiedene Gase in die Prozesskammer eingebracht werden, um Schichtensysteme abzuscheiden mit sich wiederholenden Schichtenfolgen.

Der Fortschritt bei elektronischen Bauelementen, insbesondere bei CMOS und DRAM erfordert äquivalent dünnere dielektrische Filme auf größer werdenden Substraten. Dielektrische Hoch-k-Materialien sollen SiO₂ ersetzen. Mögliche Kandidaten dieser Materialien sind beispielsweise Aluminiumoxyd oder Hafniumoxyd enthaltene Materialien. Diese einfachen Oxyde werden voraussichtlich aber nicht in der Lage sein, alle an sie gestellten Anforderungen für eine hohe dielektrische Konstante zu erfüllen, nämlich geringe Leckstromdichte und hohe thermische Stabilität. Aus diesem Grunde erscheint es erforderlich zu sein, komplexere Mischungen dieser oder ähnlicher Metalloxyde oder Dotierungen dieser Materialien zu verwenden. Darüber hinaus ist zu erwarten, dass PolySilizium durch neue Materialien als Elektroden ersetzt wird. Die Fertigung dieser Materialsysteme im industriellen Maßstab erfordert eine Abscheidungsmethode, die kosteneffizient, fertigungseffizient, hoch reproduzierbar ist und gleichförmige Filme mit hoher Reinheit mit genau definierten Interfaces ermöglicht, als auch hohe Konformalität auf strukturierten Substraten.

Die konventionelle metallorganische Gasphasendeposition (MOCVD) wurde erfolgreich angewendet, um Filme wie SiO₂ abzuscheiden. Im Vergleich zur Atomic Layer Deposition (ALD) ist die MOCVD nicht länger tauglich, um gleichmäßig die neuen komplexen Hoch-k-Schichten in einer Dicke von 10 nm abzuscheiden auf kleinen oder großen Substraten. Darüber hinaus erreicht die MOCVD nicht die hohe Konformalität auf strukturierten Substraten, wie sie erforderlich ist. Bei der ALD werden verschiedene gasförmige reaktive Substanzen abwechselnd und wiederholt dem Substrat zugeleitet. Dies erlaubt die Abscheidung von Einzelschichten (Mono Layers) basierend auf abwechselnden, selbstlimitierenden Oberflächenreaktionen. Die alternierenden Zyklen, in denen verschiedene gasförmige Reaktanten in den Reaktor geleitet werden, werden durch Pumpschritte und Spülschritte voneinander getrennt. Dies erfordert komplizierte Schaltungs- und Ventilanordnungen. Die beschränkte Antwortzeit der Ventile führt darüber hinaus zu Verzögerungen. Die Pump- und Spülzyklen nehmen den größten Teil der Prozesszeit in Anspruch, ohne dass sie zum Filmwachstum selbst beitragen. In vielen ALD-Reaktoren fließen die reaktiven Gase parallel zu der Substratoberfläche, so dass die Wachstumsrate zu längeren Zykluslängen abnehmen. Diese Merkmale führen zu einem geringen Durchsatz, insbesondere bei einer Einzel-Substrat-ALD.

Darüber hinaus sind bei der ALD als reaktive Materialien nur wenige Prekursoren brauchbar. Viele dieser Prekursoren basieren auf Chlor enthaltenden Substanzen. Ein ALD-Prozess, der auf derartigen Ausgangsstoffen, beispielsweise H₂O als Oxidationsmittel basiert, führt zu der Bildung von HCl als Nebenprodukt, welches Probleme bei der Gasentsorgung macht. Weiterhin können ALD-Verfahren, die Festkörperquellen verwenden, üblicherweise nicht die erforderliche Gasphasensättigung erreichen. Auch dies vermindert den Durchsatz des Systems. Die Probleme vermehren sich bei Systemen mit mehr als einem Substrat und bei großdimensionierten Reaktoren.

Der Erfindung liegt die Aufgabe zugrunde, das gattungsgemäße Verfahren bzw. die gattungsgemäße Vorrichtung im Hinblick auf einen höheren Durchsatz an Substraten weiterzubilden.

Gelöst wird die Aufgabe durch die in den Ansprüchen angegebene Vorrichtung bzw. das in den Ansprüchen angegebene Verfahren.

Zunächst und im Wesentlichen ist vorgesehen, dass die Prozesskammer mehrere voneinander getrennte Abscheidekammern aufweist, in welche zur Einleitung individueller Gaszusammensetzungen voneinander verschiedene Gaszuleitungen münden, und welchen das Substrat durch die Bewegung des Suszeptors nacheinander zuführbar ist, um dort voneinander verschiedene Schichten der Schichtkomponenten abzuscheiden. Das Verfahren zeichnet sich dadurch aus, dass die verschiedenen Prozessgase in voneinander getrennte Abscheidekammern der Prozesskammern eingeleitet werden und das mindestens eine Substrat durch die Bewegung des Suszeptors nacheinander den einzelnen Abscheidekammern zugeführt wird und in jeder Abscheidekammer einer der Prozessschritte durchgeführt wird. In diesem System werden die Substrate abwechselnd verschiedenen Kammern ausgesetzt, die mit unterschiedlichen gasförmigen Reaktionsmaterialien gefüllt sind. Diese Kammern sind durch eine dynamische Gasflussdichtung voneinander getrennt, so dass ein Vermischen der Gase von einander benachbarter Kammern signifikant vermindert ist. Die Gase werden unabhängig voneinander zu den Substraten geführt. Die Kombination dies mit einem kontaktfreien Verdampfungssystem und Verdampfungsmethode unter Verwendung einer nicht kontinuierlichen Injektion flüssiger oder gelöster Metallprekursoren in ein geheiztes Volumen, um die Prekursoren in die Gasphase zu überführen und sie den Kammern des Reaktors zuzuleiten, ermöglicht eine hohe Gasphasensättigung. Dies kann die notwendige Zeit, innerhalb der die Substrate den gasförmigen Reaktanten in jeder Kammer ausgesetzt werden, reduzieren, und dadurch den Durchsatz steigern. Alternativ dazu können die Prekursoren auch über eine kontinuierliche Verdampfung in hoher Sättigung der Gasphase zugeführt werden. Diesbezügliche Verfahren können Bubbler oder andere Gasversorgungssysteme oder -verfahren verwenden. Die Prekursoren können mit einer Kombination dieser Vorrichtungen oder Verfahren der Prozesskammer zugeführt werden.

Es wird als besonderer Vorteil der Erfindung angesehen, dass in die einzelnen Abscheidekammern kontinuierlich ein individuelles Prozessgas eingeleitet wird. Anders als beim Verfahren und bei der Vorrichtung, die aus dem Stand der Technik bekannt ist, braucht hier kein Gaswechsel stattzufinden, vielmehr wird das Substrat von Prozessschritt zu Prozessschritt gefördert. Die einzelnen Prozesskammern können beheizt werden. Hierzu kann die Prozesskammerdecke, welche in Form von zum Substrathalter offenen Kammern die Abscheidekammern ausbildet, beheizt werden. Es kann sogar jede einzelne Abscheidekammer individuell beheizt werden. Auch der Suszeptor kann beheizt werden. Vorzugsweise werden auch die Gaszuleitungen temperiert.

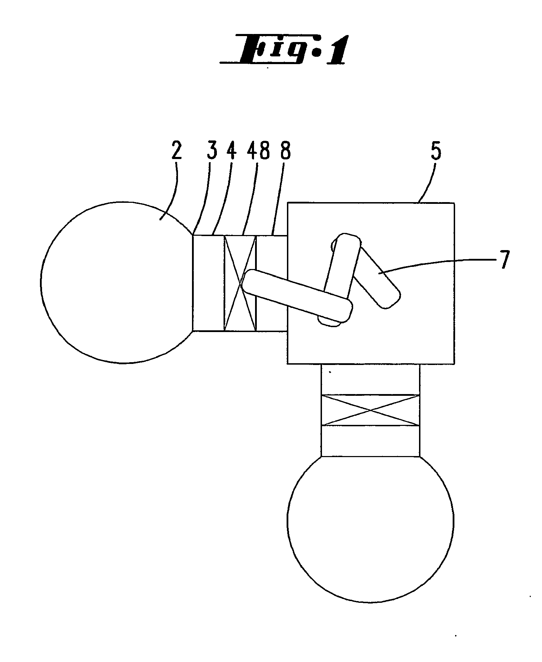

Ausführungsbeispiele der Erfindung werden nachfolgend anhand beigefügter Zeichnungen erläutert. Es zeigen
- Fig.1: in schematischer Darstellung den Aufbau eines Systems mit zwei Vakuumkammern, die an einer Vakuumtransferkammer angeschlossen sind, in welcher sich ein Roboterarm befindet. Es kann auch eine größere Anzahl von Reaktorgehäusen an die Transferkammer bzw. das Vakuumsystem angeschlossen sein;

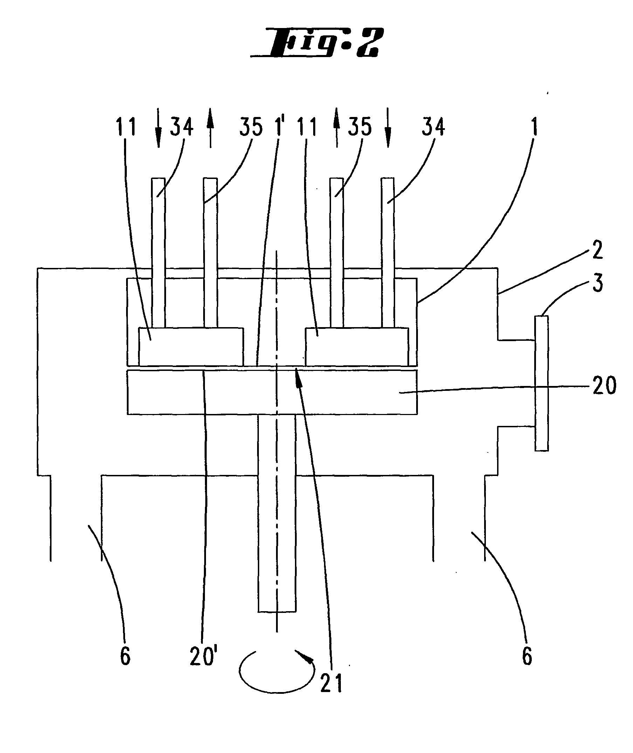

- Fig. 2: in grob schematischer Darstellung einen Querschnitt durch eine erfindungsgemäße Vorrichtung;

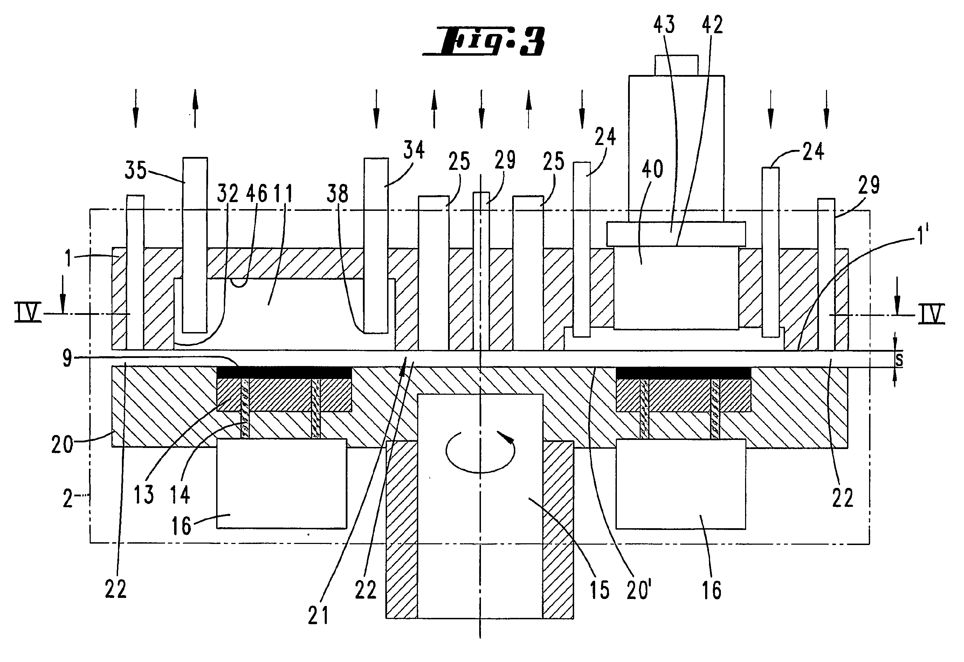

- Fig. 3: einen Querschnitt durch die Prozesskammer einer erfindungsgemäßen Vorrichtung gemäß der in der Fig. 4 dargestellten, mit III - III bezeichneten Schnittlinie, ebenfalls grob schematisch;
- Fig. 4: einen Schnitt gemäß der Linie IV - IV in Fig. 3 durch eine Prozesskammerdecke, die den die Kammern tragenden Körper ausbildet;
- Fig. 5: einen Schnitt wie Fig. 4 eines weiteren Ausführungsbeispiels und
- Fig. 6: einen Schnitt wie Fig. 4 eines weiteren Ausführungsbeispiels.

Ein Depositionskammerkörper 1 ist innerhalb einer Vakuumkammer 2 angeordnet und bevorzugt aus Metall, Quarz mit angrenzendem Vakuumflansch 3 und einem Substratlade- und -entladetor 4 gefertigt. Ein oder mehrere dieser Kammern 2 können einem externen Ladetor 8 eines Substratbeladesystems 5 zugeordnet sein. Ein oder mehrere Trenntore 48 können innerhalb des Beladetores 47 oder des externen Beladetores 8 vorgesehen sein. Das Beladesystem 5 beinhaltet eine Transferkammer mit einem automatischen Roboterarm 7, der in der Lage ist, die Substrate 9 zum Zwecke des Ladens und Entladens zu handhaben.

Der mit der Bezugsziffer 1 bezeichnete Körper bildet die Decke 1 einer Prozesskammer und ist im Reaktorgehäuse 2 angeordnet. Er hat eine Vielzahl von Abscheidekammern 11 und eine Vielzahl von Spül- und Pumpkammern 40. Der Teil, der an die Kammern angrenzt, ist ein beweglicher Suszeptor 20 mit darin angeordneten Substrathaltern 13 und einem Substrathubmechanismus 14. Der bewegbare Suszeptor 20 ist an einen horizontalen Antriebsmechanismus 15 und an einen vertikalen Hubmechanismus 16 gekoppelt. Beide, Kammerkörper 1 und bewegbarer Suszeptor 20 können mit zumindest einer äußeren Strahlungsheizung oder einer eingebauten Widerstandsheizung aufgeheizt werden. Bevorzugt haben Kammerkörper 1 und Suszeptor 20 eine kreisscheibenförmige Gestalt. Andere Gestaltungen, wie eine rechteckige Gestalt, sind aber auch möglich.

Der Suszeptor 20 mit integrierten Substrathaltern 13 und Substrathubeinrichtungen 14 kann in Horizontalrichtung bewegt, vorzugsweise rotiert gegenüber dem Kammerkörpers 1 werden, wobei ein schmaler Spalt 21 zwischen Suszeptor 20 und Kammerkörper 1 verbleibt. Der schmale Spalt 21 dient als dynamische Dichtung 22, um signifikant die Vermischung von Gasen der Abscheidekammern 11,11' und/oder der Pump- oder Spülkammer 40 zu vermeiden, so dass die Gase unabhängig voneinander den Substraten zugeführt werden können. Der Spalt ist mittels komprimiertem Inertgas gespült, welches durch einen Einlasskanal 24 eingeleitet und durch einen Auslasskanal 25 bei reduziertem Druck entfernt wird. Die Dicke s des Spaltes 21 ist so gewählt, dass minimale Gasströme aus den Abscheidekammern 11,11' austreten können. Das Substrat 9 kann in einer Vertiefung einliegen, so dass es vorzugsweise mit seiner Oberfläche mit der Oberfläche 20' des Substrathalters 20 fluchtet. Der kontrollierte Druck innerhalb des Gasspaltes kann geringfügig größer sein als der Prozessdruck innerhalb der Abscheidekammer 11 und nennenswert höher als der Druck innerhalb der daran angrenzenden Pump- und Spülkammer 40.

Der Gasspalt, der sich im Zentrum des Kammerkörpers 1 befindet, isoliert die Kammern 11,11' und 40 vom Rotations- oder Translationsmechanismus.

Eine Vielzahl von Abscheidekammern 11, 11'und Pump- und Spülkammern 40 ist innerhalb des Kammerkörpers 1 angeordnet. Jede dieser Kammern ist von der jeweils anderen durch einen schmalen Spalt 21 getrennt, der mit einem Inertgas gefüllt ist.

Jede der geeigneten und vorzugsweise topf- oder kastenartigen Abscheidekammern.11,11' hat eine Bodenfläche 56 und mindestens drei oder vier, vorzugsweise vertikal ausgerichtete Seitenwände 32. Benachbart zu den Abscheidekammern 11,11' sind im Kammerkörper 1 ein oder mehrere Zuleitungskamäle 34 für ein oder mehrere reaktive Gase vorgesehen, die mit geeigneten Endstücken 38, beispielsweise Düsen in die Kammer münden. Diese Zuleitungskanäle 34 sind mit externen Reaktivgasleitungen oder einem Vakuumsystem und einem Gasmischsystem verbunden. Um einen für eine geeignete MOCVD, ALD etc. -prozess geeigneten Druck innerhalb der Abscheidekammern 11,11' zu erzeugen, wird das Gas durch Auslasskanäle 35 entfernt. Alle Auslasskanäle 35 sind mit einer Hauptvakuumleitung und einer Vakuumpumpe verbunden.

Eine Anzahl von Sptilgaseinlasskanälen 24 und Spülgasauslasskanälen sind für die Spülkammern 40 vorgesehen In einem anders gestalteten Ausführungsbeispiel hat der obere Teil einer Spülkammer 40 eine Öffnung 42 für einen Einlassflansch 43 einer Pumpe, vorzugsweise einer Turbopumpe.

Angrenzend an jede Abscheidekammer 11, 11' oder Spülkammer 40 ist ein Abschnitt eines beweglichen Suszeptors 20. Der Suszeptor 20 kann ein Substrat 9 tragen, welches auf einem Substrathalter 13 angeordnet ist, welcher vorzugsweise ein "electrostatic chuck", also eine elektrostatische Substrathalterung aufweist. Dieser kann mit Hubstiften 14 eines Hubmechanismus 16 ausgestattet sein.

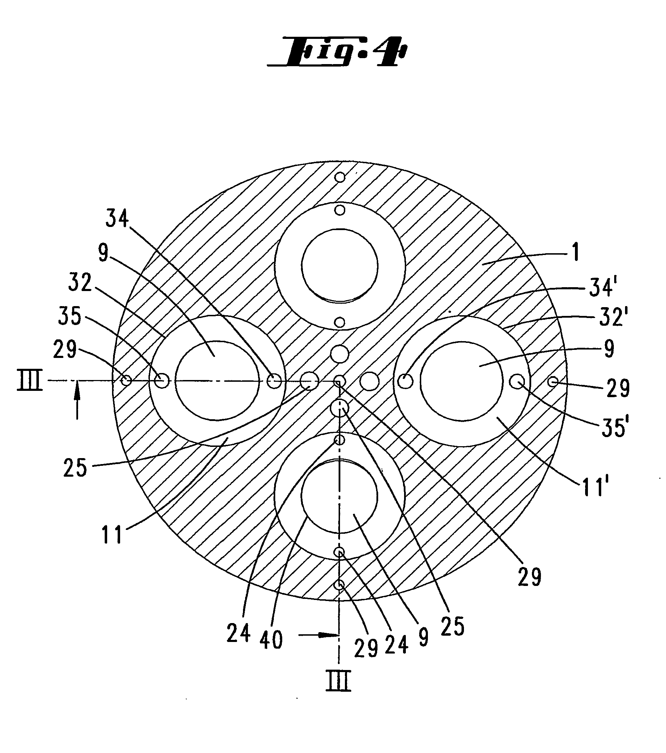

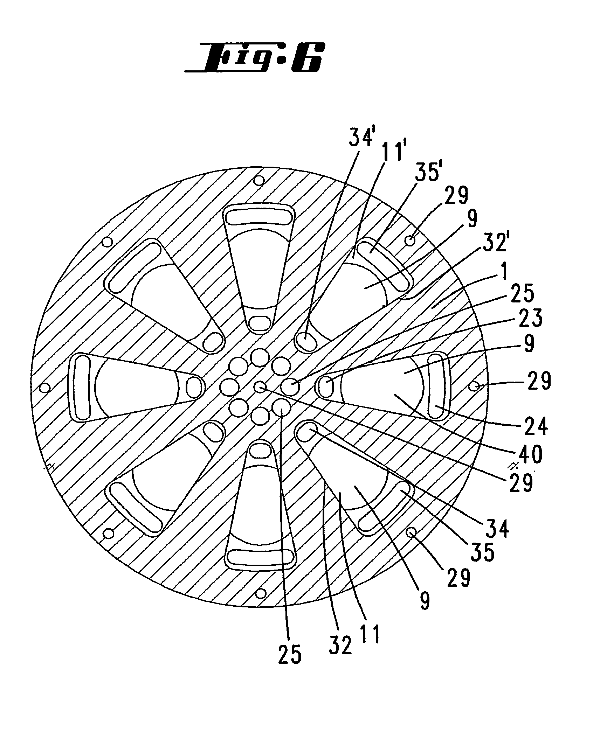

Aus der Schnittdarstellung gemäß Figur 4 geht hervor, dass bei diesem Ausführungsbeispiel zwei voneinander verschiedene Abscheidekammern 11, 11' vorgesehen sind. Jede dieser Abscheidekammern hat hier einen kreisrunden Grundriss. Der Grundriss kann aber auch anders gestaltet sein, wie beispielsweise die Figur 6 zeigt. Grundsätzlich ist es auch möglich, dass der Grundriss eine Abscheidekammer 11,11'bzw. der zwischen den beiden Abscheidekammern 11,11'liegenden Spülkammern 40 rechteckig und insbesondere quadratisch ist.

Bei dem in Figur 4 dargestellten Ausführungsbeispiel liegen auf dem Suszeptor insgesamt vier Substrate auf. In nicht dargestellten bevorzugten Ausgestaltungen liegen auf dem Suszeptor erheblich mehr, insbesondere mindestens sechs Substrate in einer ringförmigen Anordnung um das Zentrum des Suszeptors auf. Jedem der vielen Substrathalter kann eine Abscheidekammer 11,11'bzw. eine Spülkammer 40 zugeordnet sein, so dass in einer bestimmten Drehstellung des Suszeptors jedes Substrat 9 unterhalb einer Abscheidekammer 11, 11' oder unterhalb einer Spülkammer 40 liegt. Bei einer derartigen Ausgestaltung, bei der der Grundriss der einzelnen Kammern 11, 11', 40 größer ist als der Grundriss eines Substrates 9, kann der Suszeptor im Schrittbetrieb rotiert werden. Er wird getaktet weitergedreht und in Drehstellungen, in denen jedes Substrat 9 einer Kammer 11,11', 40 zugeordnet ist, für eine gewisse Zeit angehalten, in welcher Zeit die kammerspezifischen Prozesse auf der Oberfläche des Substrates 9 stattfinden können.

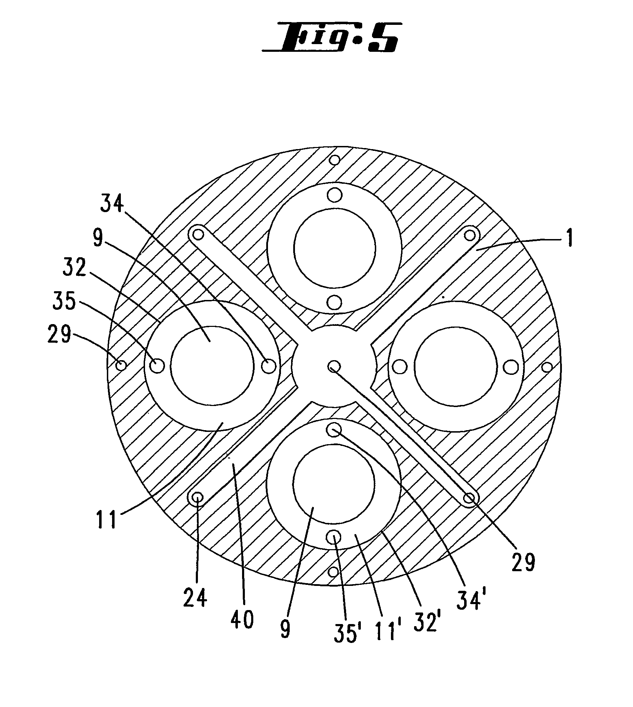

Bei dem in Figur 5 dargestellten Ausführungsbeispiel besitzen die Abscheidekammern 11,11'Grundrisse, die größer sind als die Grundrisse der Substrate 9, so dass auch diese Vorrichtung im Schrittbetrieb betrieben werden kann. Anders als bei der in Figur 4 dargestellten Vorrichtung sind hier jedoch die Spülkammern 40 erheblich schmaler gestaltet. Sie dienen im Wesentlichen dazu, eine Gasdichtung zwischen den einzelnen Abscheidekammern 11,11'zu erzeugen, so dass die unterschiedlichen Prozessgase der einzelnen Abscheidekammern 11,11' sich nicht vermischen. Die Abscheidekammer 40 besitzt hier eine im Wesentlichen kreuzartige Struktur. Der Gaseinlass des Spülgases 29 kann hier beispielsweise im Zentrum angeordnet sein. Das Spülgas kann aber auch durch den Einlass 24 in die Spülkammer 40 eingeleitet werden, welcher sich am radial äußeren Ende der jeweiligen Spülkammer 40 befindet. Jeder der beiden Kanäle 24, 29 kann alternativ aber auch als Auslass verwendet werden, so dass das Spülgas die Spülkammer 40 in Radialrichtung durchströmen kann

Auch bei diesem Ausführungsbeispiel besitzt jede der vier verschiedenen Abscheidekammern 11,11' einen Zuleitungskanal 34,34', durch welchen das individuelle Prozessgas in die Abscheidekammern 11,11' eingeleitet wird. Auch hier ist die Gestaltung des Querschnitts des Zuleitungskanals 34, 34' nur angedeutet Zur Sicherung einer homogenen Gasphasenverteilung innerhalb der Abscheidekammern 11,11' kann hier eine besondere Gestaltung vorgesehen sein. Dasselbe gilt auch für die Gestaltung des jeweiligen Auslasskanales 35, 35'.

Die Ströme durch diese beiden Kanäle 34,34'; 35,35' sind so eingestellt, dass möglichst wenig Gas in den Spalt 21 eintritt bzw. kein Spülgas durch den Spalt 21 von den Düsen 29, 35 in die Abscheidekammer 11,11' eindringt.

Die zuvor beschriebenen Anordnungen können zur Abscheidung dünner Schichten verschiedenen Typs auf Substraten in einem CVD-Prozess (beispielsweise MOCVD oder ALD oder andere ...) verwendet werden. Sowohl der kontinuierliche als auch der Batch-Betrieb sind möglich.

Bei einer typischen Prozessabfolge wird der Suszeptor 20 in eine Beladeposition für einen ersten Substrathalter 13 bewegt, und insbesondere rotiert. Der Suszeptor 20 hält an, wenn der erste Substrathalter 13 vor dem Beladetor 4 steht. Daran anschließend werden die Hubstifte 14 angehoben. Das Gastrenntor 48 öffnet. Sodann tritt ein ein Substrat 9 tragender Roboterarm 7 in die erste Höhlung 11 ein und plaziert das Substrat 9 auf den Stiften 14 oberhalb des Substrathalters 13. Mittels des Hubmechanismus 16 werden diese Stifte abgesenkt, so dass das Substrat auf dem Halter 13 ruht. Der Substrathalter 13 ist vorzugsweise ein elektrostatischer Substrathalter. Er kann aber auch mechanische Klemmittel für das Substrat aufweisen.

Sodann wird der Substrathalter 20 in eine weitere Ladeposition für den nächsten Substrathalter 13 gegenüber dem Roboterarm 7 bewegt. Nachdem die oben genannten Schritte für alle Substrathalter 13 wiederholt wurden, ist der Beladeschritt abgeschlossen. Das Trenntor 48 schließt und der leere Roboterarm 7 stellt sich in eine Neutralposition zurück. Diese beschriebene Art der Beladung betrifft das Batch-Verfahren. Das kontinuierliche Verfahren benötigt ein alternatives Beladen / Entladen, welches als "hot swap of substrates" bezeichnet wird: In diesem Falle wird das bereits prozessierte Substrat vom Roboterarm genommen und ein Roh-Substrat auf den leeren Substrathalter gelegt. Hierfür wird vorzugsweise ein Hochgeschwindigkeits-Zwillings-Arm Roboter verwendet.

Wenn der Suszeptor 20 mit dem Substrathalter 13 zu drehen beginnt, treten die Substrate zu einem bestimmten Zeitpunkt in eine Abscheidekammer 11 ein. Die Temperatur der Kammer und die Substrattemperatur innerhalb der Kammer 11 wird konstant gehalten und ist an die gewünschte chemische Reaktion innerhalb der Kammer angepasst. Innerhalb der Kammer 11 befindet sich ein stetiger, vorzugsweise in Horizontalrichtung verlaufender Fluss von reaktiven Gasen oder Dämpfen zwischen der Einlassdüse 34 und der Auslassöffnung 35. Dieser Gasfluss wird kontinuierlich aufrecht erhalten. Das reaktive Gas oder der reaktive Dampf formt eine dünne Schicht eines Materials auf der Oberfläche des Substrates, welche zur Abscheidekammer 11 weist. Sobald der gewünschte Film oder die gewünschte Oberflächenbeschichtung erreicht ist, verlässt das Substrat die Abscheidekammer 11 und bewegt sich zu einer Pump-/
Spülkammer 40 und/oder zur nächsten Abscheidekammer 11'.

Um die benachbarten Kammern 11 voneinander und von der den Abscheidekammerkörper umgebenden Vakuumbereich 2 zu isolieren, ist eine Vielzahl
von dynamischen Dichtungsgebieten 22 vorgesehen. Diese wirken zwischen Kammerkörper 1 und Suszeptor 20 als schmaler Spalt 21 zwischen Kammerkörper 1 und Suszeptor 20. Dieser Spalt wird kontinuierlich mit einem Inertgas gespült. Die Inertgasversorgung erfolgt durch die Kanäle 29. Es wird ein geeigneter Druckgradient zwischen dem Spalt, den Kammern und dem Inneren des Vakuumrezipienten aufrechterhalten. Der Spalt formt eine dynamische Vakuumdichtung, die verhindert, dass reaktive Gase zwischen den verschiedenen Höhlungen 11 und der Höhlung des Vakuumrezipientens außerhalb des Reaktorkörpers 1 fließen.

Bei dem in Figur 6 dargestellten Ausführungsbeispiel ist der Grundriss der Spülkammern 40 bzw. der verschiedenen Abscheidekammern 11,11' in Umfangsrichtung gesehen kleiner als der Durchmesser der kreisscheibenförmigen Substrate 9. Mit dieser Vorrichtung ist eine kontinuierliche Drehung des Substrathalters 20 möglich. Der Grundriss der Abscheidekammern 11,11' bzw. der Spülkammer 40 ist so gewählt, dass jeder Punkt des Substrates eine gleiche Verweildauer innerhalb der Spülkammer 40 bzw. der Abscheidekammern 11,11' besitzt. Insbesondere ist der Grundriss kreissegmentförmig.

Zur Erzeugung der in die Abscheidekammern einzuleitenden Prozessgase kann beispielsweise eine Verdampfungsvorrichtung verwendet werden, wie sie die EP 1098 015 A1 beschreibt

Als Verdampfer eignet sich aber auch die in der EP 1320 636 A1 beschriebene Vorrichtung.

Schliesslich ist auch vorgesehen, dass die Verdampfung flüssiger oder in einer Flüssigkeit gelöster Prekursoren in einer Vorrichtung und nach einem Verfahren erfolgt, wie es die DE 100 57 491 A1 beschreibt.

## Patentansprüche

1. Vorrichtung zum Abscheiden mindestens einer insbesondere dünnen Schicht auf mindestens einem Substrat (9), mit einem Reaktorgehäuse (2) und einer darin angeordneten Prozesskammer, die einen um eine Drehachse drehbaren, einen oder mehrere Substrathalter (13) aufweisenden, kreisscheibenförmigen Suszeptor (20) und eine Vielzahl von um die Drehachse angeordnete, voneinander getrennte Abscheidekammern (11,11') aufweist, deren in einer gemeinsamen Ebene liegenden Öffnungen unter Ausbildung eines Abstandsspaltes (21) dem Suszeptor (20) gegenüberliegen, wobei jede der Abscheidekammern (11,11') eine mit einem Gasmisch- und Versorgungssystem verbundene Gaszuleitung (34, 34') und eine Gasableitung (35, 35') aufweist, zur Zuleitung und zur Ableitung voneinander verschiedener Prozessgase, die schichtbildende Komponenten beinhalten, wobei das auf einem Substrathalter (13) des Suszeptors (20) aufliegende Substrat (9) durch Drehen des Suszeptors (20) nacheinander den verschiedenen Abscheidekammern (11,11') zuführbar ist, um dort in zeitlich aufeinanderfolgenden Schritten voneinander verschiedene Schichten oder Schichtkomponenten abzuscheiden, **dadurch gekennzeichnet, dass** das Gasmischsystem ein kontaktfreies Verdampfungssystem ist, bei dem flüssige oder gelöste Prekursoren nicht kontinuierlich in ein geheiztes Volumen injiziert werden, um die Prekursoren in die Gasphase zu überführen, um sie durch die Gaszuleitung (34) den Abscheidekammern (11, 11') zuzuleiten, die eine Topfform mit einem kreisrunden Grundriss aufweisen und von Aussparungen einer Prozesskammerdecke (1) gebildet sind.

2. Vorrichtung nach Anspruch 1, **gekennzeichnet durch** mindestens eine zwischen zwei Abscheidekammern (11,11') angeordnete Spüleinrichtung (40) insbesondere in Form einer Spülkammer.

3. Vorrichtung nach einem der vorangehenden Ansprüche, **gekennzeichnet durch** im Bereich zwischen zwei benachbarten Abscheide- (11,11')/ oder Spülkammern (40) angeordnete Gasaustrittsdüsen insbesondere für ein Dichtgas.

4. Vorrichtung nach einem der vorangehenden Ansprüche, **gekennzeichnet durch** von einem Hubmechanismus (16,14) anhebbare Substrathalter (13).

5. Vorrichtung nach einem der vorangehenden Ansprüche, **dadurch gekennzeichnet, dass** die Form, die Größe und die Position der Abscheidekammern derartig gewählt sind, dass die auf dem Suszeptor (20) angeordneten Substrate (9) bei einer bestimmten Drehstellung des Suszeptors (20) jeweils einer individuell ihnen zugeordneten Abscheidekammer (11,11') und/oder Spülkammer (40) oder einem Zwischenraum zwischen den Kammern (11,11', 40) zugeordnet sind.

6. Vorrichtung nach einem der vorangehenden Ansprüche, **dadurch gekennzeichnet, dass** die Gaszuleitungen temperiert sind.

7. Vorrichtung nach einem der vorangehenden Ansprüche, **dadurch gekennzeichnet, dass** der Hubmechanismus (16) vertikal ausgerichtet, auf der Unterseite des Substrates (9) angreifende Hubstifte (14) oder Hubringe aufweist.

8. Vorrichtung nach einem der vorangehenden Ansprüche, **gekennzeichnet durch** eine oder mehrere Heizeinrichtungen zur Temperierung des Suszeptors (20) und/oder der Wände der Abscheide- und/oder Spülkammern (11,11', 40).

9. Verfahren zum Abscheiden mindestens einer insbesondere dünnen Schicht auf mindestens einem Substrat (9) in einer einem Reaktorgehäuse (2) angeordneten Prozesskammer (11,11'), in welcher das Substrat (9) von einem bewegbaren Suszeptor (20) getragen wird und in welche verschiedene Prozessgase eingeleitet werden, die schichtbildende Komponenten beinhalten, die in aufeinanderfolgenden Prozessschritten auf dem Substrat (9) abgeschieden werden, wobei die verschiedenen Prozessgase in voneinander getrennte Abscheidekammern (11,11') der Prozesskammer eingeleitet werden und das mindestens eine Substrat durch die Bewegung des Suszeptors (20) nacheinander den einzelnen Abscheidekammern (11,11') zugeführt wird und in jeder Abscheidekammer (11,11') einer der Prozessschritte durchgeführt wird, **dadurch gekennzeichnet, dass** die Prozessgase in einem Gasmischsystem durch nicht kontinuierliches und kontaktfreies Verdampfen flüssiger oder in einer Flüssigkeit gelöster Prekursoren erzeugt werden, wobei die flüssigen oder in einer Flüssigkeit gelösten Prekursoren durch Injektion in ein geheiztes Volumen in die Gasphase überführt werden.

10. Verfahren nach Anspruch 9, **dadurch gekennzeichnet, dass** die abgeschiedenen Schichten aus zwei oder mehreren Komponenten bestehen, die insbesondere aus Elementen der Hauptgruppen II und VI, III und V oder IV bestehen, wobei die Komponenten in verschiedenen Abscheidekammern abgeschieden werden.

11. Verfahren nach einem der Ansprüche 9 oder 10, **dadurch gekennzeichnet, dass** die Komponenten in Monolagen auf dem Substrat (9) abgeschieden werden.

12. Verfahren nach einem der Ansprüche 9 bis 11, **dadurch gekennzeichnet, dass** die Abscheidekammern (11,11') kontinuierlich mit den ihnen zugeordneten Prozessgasen durchströmt werden.

13. Verfahren nach einem der Ansprüche 9 bis 12, **dadurch gekennzeichnet, dass** der in die Abscheide- und/oder Spülkammer (11,11', 40) einströmende Gasstrom genauso groß ist wie der aus der Abscheide- und/oder Spülkammer austretende Gasstrom.

14. Verfahren nach einem der Ansprüche 9 bis 13, **dadurch gekennzeichnet, dass** die Substrate (9) abwechselnd verschiedenen Abscheidekammern (11) zugeordnet werden, wobei eine Abscheidekammer (11, 11') ein ein Metall enthaltendes Gas beinhaltet, welches zur Abscheidung einer Metallschicht auf dem Substrat führt und wobei die Substrate (9) dann einer davon verschiedenen Abscheidekammer (11') zugeordnet werden, welche ein anderes Gas beinhaltet, das mit der zuvor abgeschiedenen Metallschicht reagiert.

15. Verfahren nach einem der Ansprüche 9 bis 14, **dadurch gekennzeichnet, dass** die Substrate zwischen der Zuordnung zu zwei Abscheidekammern (11,11'), die jeweils ein reaktives Gas beinhalten, einer dazwischen liegenden Spülkammer (40) zugeordnet werden, die ein inertes Spülgas enthält und/oder welche zu einem niedrigeren Druck evakuiert ist als die benachbarten Abscheidekammern.

## Claims

1. Apparatus for depositing at least one in particular thin layer on at least one substrate (9), having a reactor housing (2) and a process chamber which is disposed therein and has a susceptor (20) of circular-disk shape, which can be rotated about an axis of rotation and has one or more substrate holders (13), the process chamber also having a plurality of deposition chambers (11, 11') which are separate from one another and disposed about the axis of rotation and the openings of which, located in a common plane, are located opposite the susceptor (20), with a spacing gap (21) being formed in the process, each of the deposition chambers (11, 11') having a gas feed line (34, 34') connected to a gas-mixing and supply system, and a gas discharge line (35, 35') for delivery and discharge of process gases which are different from one another and contain layer-forming components, it being possible for the substrate (9) resting on a substrate holder (13) of the susceptor (20) to be conveyed to the different deposition chambers (11, 11') one after the other by rotation of the susceptor (20), in order for layers or layer components that are different from one another to be deposited there in successive steps timewise, **characterized in that** the gas-mixing system is a contact-free vaporization system in which liquid or dissolved precursors are injected non-continuously into a heated volume in order to convert the precursors into the gas phase in order to feed them, through the gas feed line (34), to the deposition chambers (11, 11'), which are of cup shape with a circular outline and are formed by recesses in a process-chamber top (1).

2. Apparatus according to Claim 1, **characterized by** at least one purging arrangement (40), in particular in the form of a purging chamber, disposed between two deposition chambers (11, 11').

3. Apparatus according to either of the preceding claims, **characterized by** gas-outlet nozzles, in particular for a sealing gas, disposed in the region between two adjacent deposition chambers (11, 11') and/or purging chambers (40).

4. Apparatus according to any of the preceding claims, **characterized by** substrate holders (13) which can be raised by a lifting mechanism (16, 14).

5. Apparatus according to any of the preceding claims, **characterized in that** the shape, the size and position of the deposition chambers are selected such that, in a particular rotary position of the susceptor (20), the substrates (9) disposed on the susceptor (20) are each assigned to an individually associated deposition chamber (11, 11') and/or purging chamber (40) or an interspace between the chambers (11, 11', 40).

6. Apparatus according to any of the preceding claims, **characterized in that** the gas feed lines are temperature-controlled.

7. Apparatus according to any of the preceding claims, **characterized in that** the lifting mechanism (16) has vertically oriented lifting pins (14) or lifting rings acting on the underside of the substrate (9).

8. Apparatus according to any of the preceding claims, **characterized by** one or more heating arrangements for controlling the temperature of the susceptor (20) and/or of the walls of the deposition and/or purging chambers (11, 11', 40).

9. Method of depositing at least one in particular thin layer on at least one substrate (9) in a process chamber (11, 11') which is disposed in a reactor housing (2), in which the substrate (9) is carried by a movable susceptor (20) and into which are introduced different process gases which contain layer-forming components that are deposited on the substrate (9) in successive process steps, the different process gases being introduced into deposition chambers (11, 11') of the process chamber which are separate from one another, and the at least one substrate being conveyed to the individual deposition chambers (11, 11'), one after the other, by the movement of the susceptor (20), and one of the process steps being carried out in each deposition chamber (11, 11'), **characterized in that** the process gases are generated in a gas-mixing system by non-continuous and contact-free vaporization of liquid precursors or precursors dissolved in a liquid, the liquid precursors or precursors dissolved in a liquid being converted into the gas phase by injection into a heated volume.

10. Method according to Claim 9, **characterized in that** the deposited layers comprise two or more components made up, in particular, of elements of the main groups II and VI, III and V or IV, the components being deposited in different deposition chambers.

11. Method according to either of Claims 9 and 10, **characterized in that** the components are deposited on the substrate (9) in mono layers.

12. Method according to any of Claims 9 to 11,
**characterized in that** the deposition chambers (11, 11') have the process gases which are associated with them flowing through them continuously.

13. Method according to any of Claims 9 to 12,
**characterized in that** the gas stream flowing into the deposition and/or purging chamber (11, 11', 40) is equal in size to the gas stream passing out of the deposition and/or purging chamber.

14. Method according to any of Claims 9 to 13,
**characterized in that** the substrates (9) are alternately associated with different deposition chambers (11), one deposition chamber (11, 11') containing a metal-containing gas which results in a metal layer being deposited on the substrate, the substrates (9) then being assigned to a deposition chamber (11') which is different from said one deposition chamber (11), this chamber (11') containing another gas which reacts with the previously deposited metal layer.

15. Method according to any of Claims 9 to 14,
**characterized in that** the substrates, between their assignment to two deposition chambers (11, 11'), each containing a reactive gas, are assigned to a purging chamber (40) located between the deposition chambers, the purging chamber containing an inert purging gas and/or being evacuated to a lower pressure than the adjacent deposition chambers.

## Revendications

1. Dispositif de dépôt d'au moins une couche, notamment mince, sur au moins un substrat (9), ledit dispositif comportant un boîtier de réacteur (2) dans lequel est disposée une chambre de réaction qui comporte un suscepteur discoïdal (20), lequel est apte à tourner autour d'un axe de rotation et possède un ou plusieurs porte-substrat (13), et un grand nombre de chambres de dépôt (11, 11') qui sont séparées l'une de l'autre et disposées autour de l'axe de rotation et dont les ouvertures, situées dans un plan commun, sont disposées en face du suscepteur (20) en ménageant un écartement (21), chacune des chambres de dépôt (11, 11') comportant un conduit d'amenée de gaz (34, 34'), relié à un système d'alimentation et de mélange, et un conduit d'évacuation de gaz (35, 35') pour amener et évacuer différents gaz de réaction qui contiennent des composants de formation de couche, le substrat (9) placé sur un porte-substrat (13) du suscepteur (20) pouvant être amené successivement aux différentes chambres de dépôt (11, 11') en faisant tourner le suscepteur (20) afin d'y déposer différentes couches ou différents composants de couche à des étapes temporellement successives, **caractérisé en ce que** le système de mélange de gaz est un système de vaporisation sans contact dans lequel des précurseurs liquides ou en solution sont injectés de façon discontinue dans un volume chauffé pour transformer les précurseurs en la phase gazeuse afin de les amener, par le biais du conduit d'amenée de gaz (34), aux chambres de dépôt (11, 11') qui ont une forme d'une cavité circulaire en projection sur un plan et qui sont formés par des évidements ménagés dans un couvercle de chambre de réaction (1).

2. Dispositif selon la revendication 1, **caractérisé par** au moins un dispositif de rinçage, se présentant notamment sous la forme d'une chambre de rinçage, qui est disposé entre deux chambres de dépôt (11, 11').

3. Dispositif selon l'une des revendications précédentes, **caractérisé par** des buses de sortie de gaz, notamment de gaz dense, qui sont disposées dans la zone située entre deux chambres de dépôt (11, 11') ou de rinçage (40) adjacentes.

4. Dispositif selon l'une des revendications précédentes, **caractérisé par** des porte-substrat (13) pouvant être soulevés par un mécanisme de levage (16, 14).

5. Dispositif selon l'une des revendications précédentes, **caractérisé en ce que** la forme, la taille et la position des chambres de dépôt sont choisies de telle sorte que les substrats (9) disposés sur le suscepteur (20) sont associés chacun, dans une certaine position en rotation du suscepteur (20), à une chambre de dépôt (11, 11') et/ou chambre de rinçage (40) et/ou un espace entre les chambres (11, 11', 40) qui leur sont individuellement associés.

6. Dispositif selon l'une des revendications précédentes, **caractérisé** dans ce que les conduits d'amenée de gaz sont équilibrés en température.

7. Dispositif selon l'une des revendications précédentes, **caractérisé en ce que** le mécanisme de levage (16) possède des tiges de levage (14) ou des bagues de levage, orientées verticalement, qui s'engagent avec le côté inférieur du substrat (9).

8. Dispositif selon l'une des revendications précédentes, **caractérisé par** un ou plusieurs dispositifs de chauffage destinés à équilibrer en température le suscepteur (20) et/ou les parois des chambres de dépôt et/ou de rinçage (11, 11', 40).

9. Procédé de dépôt d'au moins une couche, notamment mince, sur au moins un substrat (9) dans une chambre de réaction (11, 11') qui est disposée dans un boîtier de réacteur (2), dans laquelle le substrat (9) est porté par un suscepteur mobile (20) et dans laquelle sont introduits différents gaz de réaction qui contiennent des composants de formation de couche qui sont déposés sur le substrat (9) à des étapes de réaction successives, les différents gaz de réaction étant introduits dans des chambres de dépôt (11, 11'), séparées l'une de l'autre, de la chambre de réaction et l'au moins un substrat étant amené successivement aux chambres de dépôt individuelles (11, 11') en déplaçant le suscepteur (20) et est conduit à travers chaque chambre de dépôt (11, 11') à une des étapes de réaction, **caractérisé en ce que** les gaz de réaction sont générés dans un système de mélange de gaz par vaporisation discontinue et sans contact de précurseurs liquides ou dissous dans un liquide, les précurseurs liquides ou dissous dans un liquide étant convertis en la phase gazeuse par injection dans un volume chauffé.

10. Procédé selon la revendication 9, **caractérisé en ce que** les couches déposées comportent deux ou plusieurs composants qui incluent notamment des éléments des groupes principaux II et VI, III et V ou IV, les composants étant déposés dans différentes chambres de dépôt.

11. Procédé selon l'une des revendications 9 ou 10, **caractérisé en ce que** les composants sont déposés en monocouches sur le substrat (9).

12. Procédé selon l'une des revendications 9 à 11, **caractérisé en ce que** les chambres de dépôt (11, 11') sont traversées de façon continue par les gaz de réaction qui leur sont associés.

13. Procédé selon l'une des revendications 9 à 12, **caractérisé en ce que** le flux de gaz entrant dans la chambre de dépôt et/ou de rinçage (11, 11', 40) est égal au flux de gaz sortant de la chambre de dépôt et/ou de rinçage.

14. Procédé selon l'une des revendications 9 à 13, **caractérisé en ce que** les substrats (9) sont attribués alternativement à différentes chambres de dépôt (11), une chambre de dépôt (11, 11') contenant un gaz qui contient un métal et conduit au dépôt d'une couche de métal sur le substrat, les substrats (9) étant ensuite attribués à une chambre de dépôt différente (11'), qui contient un autre gaz qui réagit avec la couche de métal déposée auparavant.

15. Procédé selon l'une des revendications 9 à 14, **caractérisé en ce que**, entre l'attribution à deux chambres de dépôt (11, 11') qui contiennent chacune un gaz de réaction, les substrats sont attribuiés à une chambre de rinçage intermédiaire (40) qui contient un gaz de rinçage inerte et/ou dans laquelle on abaisse la pression jusqu'à atteindre une pression inférieure à celle des chambres de dépôt adjacentes.
